# EUROPÄISCHE PATENTANMELDUNG

(11) **EP 1 995 534 A1**
(43) Veröffentlichungstag der Anmeldung: **26.11.2008**
(21) Anmeldenummer: 07108508.8
(22) Anmeldetag: 19.05.2007
(51) Int. Cl.: F24J 2/54, F24J 2/16, H01L 31/042

(54) **Steuerung und Antrieb eines kippbaren Solarreflektors zur Leistungssteigerung und zum Schutz von flächigen Sonnenkollektoren**

(71) Anmelder: Brinkmann, Fritz, 75446 Wiernsheim (DE)
(72) Erfinder: Brinkmann, Fritz, 75446 Wiernsheim (DE)

(57) **Zusammenfassung**

Ein L-Förmiger schwenkbarer Träger mit einer reflektierenden Fläche (4) wird oberhalb eines Sonnenkollektors (2) so geführt, dass zusätzliche Strahlung auf den Kollektor reflektiert wird. Damit wird die Leistung des Sonnenkollektors gesteigert und gesteuert. Die Steuerung der Einrichtung basiert auf astronomischen Daten.

## Beschreibung

Es ist Stand der Technik, Sonnenkollektoren zur Gewinnung von Wärme oder Strom aus Sonnenstrahlung in eine feste Lage z.B. auf Hausdächer zu montieren.
Der Ertrag hängt wesentlich von der Kollektorfläche, von der Kollektorlage und von der Jahreszeit ab. Die Kollektorlage wird üblicherweise an vorhandene Flächen angepasst. Sie wird meistens von Dachneigung und Firstrichtung beeinflusst.

Im Winter bei hohem Wärmeenergiebedarf ist der Ertrag wegen des niedrigen Sonnenstandes geringer als im Sommer. Zusätzlich kann der Winterertrag mehr als der Sommerertrag durch geringe Dachneigungen und durch von der Südrichtung abweichende Ausrichtung negativ beeinflusst werden. Bisher wird bei ungünstigen Lagen meistens eine größere Kollektorfläche empfohlen.

Herkömmliche Kollektoren werden vom Schnee zugedeckt und tauen nur langsam wieder frei. Eintreffende Sonnenenergie kann während dieser Zeit nicht genutzt werden.

Während klarer Nächte bildet sich Reif beziehungsweise Tau, der erst abtrocknen muß, bevor die volle Leistung der Anlage genutzt werden kann.

Im Sommer bei steil stehender Sonne steht fast immer eine Überangebot an Wärme zur Verfügung. Der Wärmespeicher wird auf 85 bis 95°C aufgeheizt bis die Anlage abschaltet. Die Kollektortemperatur steigt weiter an, was die Alterung der Kollektoren und der Wärmeträgerflüssigkeit beschleunigt. Leitungen und Wärmespeicher geben auch bei sorgfältiger Isolierung Strahlungswärme und Konvektionswärme an das Hausinnere ab, was die Hausbewohner als unangenehme zusätzliche Aufheizung empfinden. Die Brauchwasserleitungen im Wärmetauscher neigen bei hohen Temperaturen zum Verkalken.
Bei Abwesenheit der Bewohner zum Beispiel im Sommerurlaub wird keine Wärme benötigt. Herkömmliche Kollektoranlagen fördern unabhängig vom Bedarf Wärme ins Haus und verbrauchen dabei elektrische Energie für die Pumpen.

Es ist es vorteilhaft, eine Vorrichtung zur bedarfsgerechten Leistungssteigerung zu installieren. Weiterhin ist es vorteilhaft, diese Vorrichtung bei Leistungsüberschuß zur Leistungs- und Temperaturbegrenzung zu nutzen.

Dazu sind folgende Druckschriften bekannt:

| | | |
|---|---|---|
| 1. | DE 100 32 227 | (F24 J 2/46) |
| 2. | FR 1.223.571 | (G 02 b - H01) |
| 3. | DE 44 25 126 A1 | (G 05 D 3/00) |

darin werden Reflektoren/ Spiegel beschrieben, die beweglich oberhalb von Sonnenkollektoren angebracht werden.

Es hat sich als ausreichend und günstig herausgestellt, bei breiteren Kollektorflächen eine Drehbewegung der Spiegelfläche nur um eine Achse auszuführen, wobei diese Achse oberhalb der Kollektoren nahezu waagerecht verläuft.

Bei längeren Kollektoren mit geringer Breitenausdehnung ist es ausreichend, die Drehbewegung um zwei Achsen auszuführen wobei die erste Achse oberhalb der Kollektoren waagerecht verläuft. Um die erste Achse wird die zweite Achse gedreht. Um die zweite Achse wird die Spiegelfläche gedreht. Die zweite Achse wird nahezu im rechten Winkel zur ersten Achse angeordnet.

Andere Anordnungen mit zusätzlichen Freiheitsgraden wurden untersucht und wegen dem hohen Aufwand vorerst zurückgestellt:
Vorteilhaft könnte die aus dem Werkzeugbau bekannte Pentapod-Technologie sein. Dabei wird der Spiegel an fünf Hubzylindern befestigt. Damit ließe sich der Spiegel frei im Raum bewegen und optimal justieren.

Der Reflektor/ Spiegel wird günstigerweise als rechteckige Ebene ausgeführt und kann in seinen Abmessungen Länge und Breite von den Kollektormaßen abweichen.

Die über den Reflektor beleuchtete Fläche ergibt ein Parallelogramm auf der Kollektorebene. Die Steuerung wird so ausgeführt, daß die stumpfen Ecken des Parallelogramms über die zugehörigen Kollektorecken passen. Die spitzen Ecken ragen dabei über die Kollektorfläche hinaus.

Mit einer in sich verformbaren Reflektorfläche kann aus dem Parallelogramm ein Rechteck geformt werden. Der daraus resultierende Vorteil ist jedoch gering.

Ungenauigkeiten in der Steuerung sind von geringerem Einfluss, wenn die über den Spiegel beleuchtete Fläche größer ist als die Kollektorfläche, da in diesem Fall eine Kompensation durch die vergrößerte in Sonnenrichtung projezierte Reflektorfläche stattfindet. Wenn die Ungenauigkeit zu einer verkleinerten beleuchteten Fläche führt, wird der Leistungsverlust stärker.

Aufgrund der guten Reflektionseigenschaften von Aluminium im Bereich des sichtbaren und des infraroten Lichts eignet sich für den Reflektor eine Aluminiumoberfläche besonders für solarthermische Anlagen. Es hat sich als günstig herausgestellt, ein Aluminiumblech mit glatter Oberfläche (poliert oder glatt gewalzt) zu verwenden. Für Photovoltaikanlagen kann ein silber beschichteter Glasspiegel zu einem höheren Ertrag führen.

Der Antrieb kann kostengünstig mit relativ kleinen Elektromotoren und zum Beispiel mit einem oder mehreren Spindelgetrieben ausgeführt werden. Der Spindeltrieb erzeugt dabei die lineare Bewegung eines Schlittens, der über eine Gelenkstange mit einem an der Gegenseite befestigten Lager verbunden ist. Für die Ausführung mit zweiachsiger Lagerung des Reflektors sind zwei Antriebseinheiten vorzusehen. Um Korrosion zu vermeiden können die Spindel aus nichtrostendem Stahl und die Spindelmuttern aus trockenlaufendem schmiermittelfreiem Kunststoff hergestellt werden.

Alternativ kann der Antrieb auch mit Zahnriemengetrieben ausgeführt werden. Diese Antriebsvorrichtung kann auf die Rückseite des Reflektors montiert werden.

Die Steuerung der Spiegelposition kann mit einer einfachen ungefähren Berechnung ergänzt durch Helligkeitssensoren durchgeführt werden.
Günstiger ist es jedoch, die aus der Astronomie bekannten Formeln so in das Steuergerät zu programmieren, dass der Sonnenstand laufend abhängig von Uhrzeit und Datum errechnet wird. Der Vektor des eintreffenden Sonnenlichts wird umgerechnet auf den Standort und auf die feste Lage des Sonnenkollektors. Daraus wird eine sinnvolle Spiegelpositionierung errechnet. Mit Hilfe eines Prototypen konnte praktisch nachgewiesen werden, dass diese Methode ausreichend genau ist.

Bei der Installation der Anlage können die Größen Längen- und Breitengrad, Firstrichtung, Dachneigung, evtl. vorhandene seitliche Kippung des Kollektors, die Kollektorgröße und Lage in die Steuerung als Parameter eingefügt werden. Um ausreichend genau, zuverlässig und automatisch auf die notwendigen Größen Datum und Uhrzeit zugreifen zu können empfiehlt sich der Empfang von Funksignalen (z.B. DCF 77).

Für die Berechnung des Sonnenstands eignen sich die Formeln aus dem Buch **Astronomical Algorithms ISBN:** 978-0943396613 des belgischen Mathematikers Jean Meeus.

Die Vorrichtung ist sowohl für solarthermische als auch für photovoltaische Anlagen geeignet, wenn diese stationär (nicht mobil) betrieben werden.

Das Programm für die Steuerung des Prototypen wurde in C2 (einer C-ähnlichen Programmiersprache) geschrieben und wird von einem Single-Chip-Microcontroller des Typs C164CI ausgeführt. Dieses Gerät hat noch Kapazitäten frei und kann damit weitere Funktionen der Haus- und Heizungssteuerung übernehmen.

### Bezugszeichenliste:

1. Aufstellfläche z.B. Dachfläche
2. Kollektorfläche Sonnenkollektor oder Photovoltaikelement
3. L-förmiger Träger
4. Reflektor (Spiegel)
5. erste Achse
6. zweite Achse
7. erster Schlitten
8. zweiter Schlitten
9. erste Schub-/Zugstange
10.zweite Schub-/Zugstange
11. Stützlager
12. direkte Sonnenstrahlung auf Kollektor
13.direkte Sonnenstrahlung auf Reflektor (Spiegel)
14.reflektierte Sonnenstrahlung von Reflektor auf Kollektor
15. erster Motor
16.erste Spindel
17.zweiter Motor
18.zweite Spindel
19.erster Endschalter
20.erster Magnetfeldsensor
21. zweiter Endschalter
22.zweiter Magnetfeldsensor
23. Sturmsicherungsschloß
24.Antenne für Zeitsignal (z.b. DCF77)
25.Windstärkesensor / Anemometer
26. Steuergerät
27. Programm
28.Standortspezifische Parameter (Längengrad, Breitengrad, Ausrichtung ...)
29.Wärmebedarf eines gut isolierten Einfamilienhauses für Heizung und Brauchwasser
30. Solarertrag mit herkömmlichem Sonnenkollektor
31. Solarertrag mit erfindungsgemäßem Reflektorsystem

Es folgen fünf Seiten mit Zeichnungen:

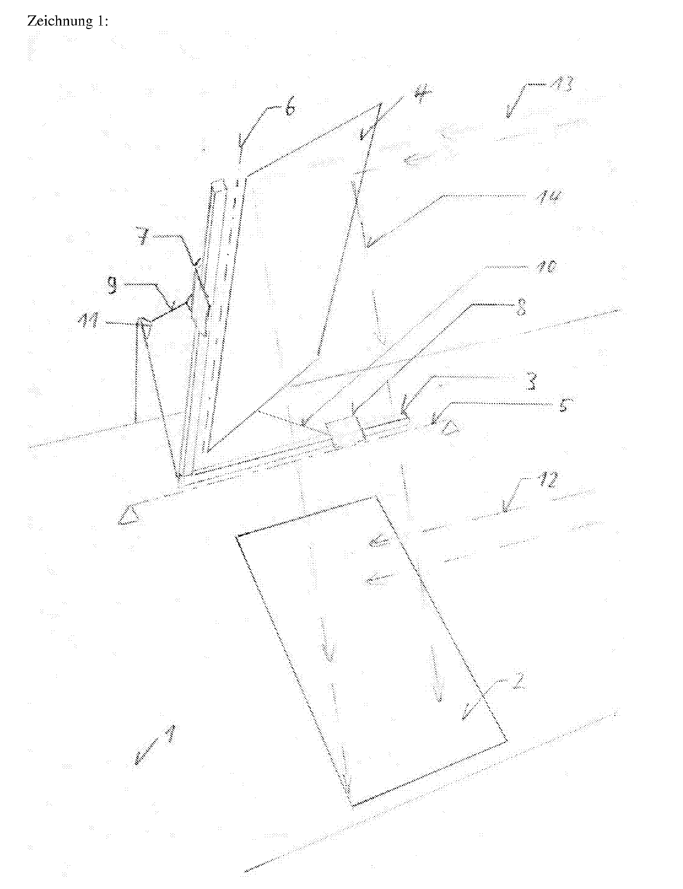

- Zeichnung 1 - perspektivische Ansicht auf das geöffnete System

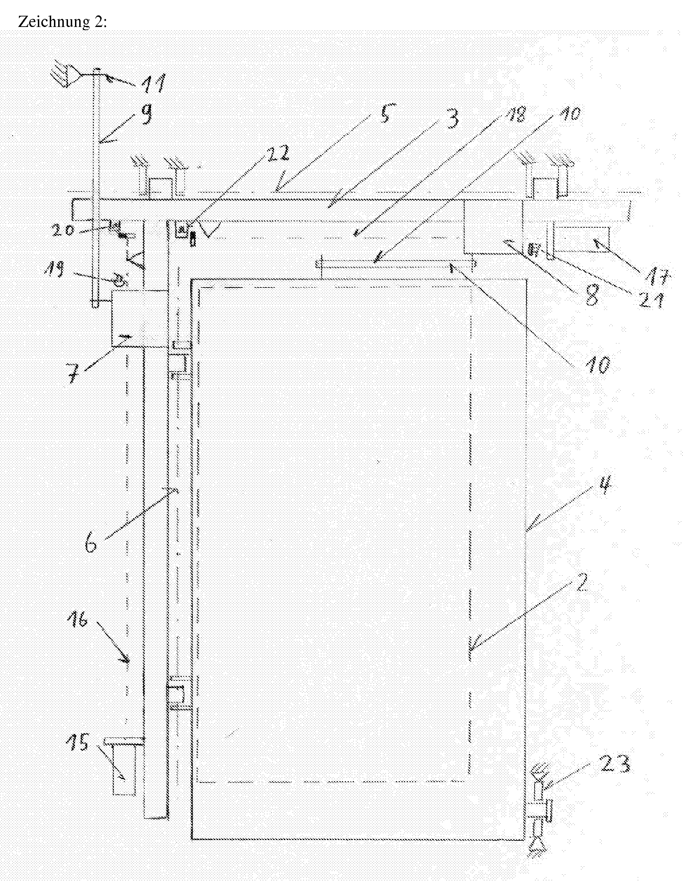

- Zeichnung 2 - normale Ansicht auf das geschlossene System

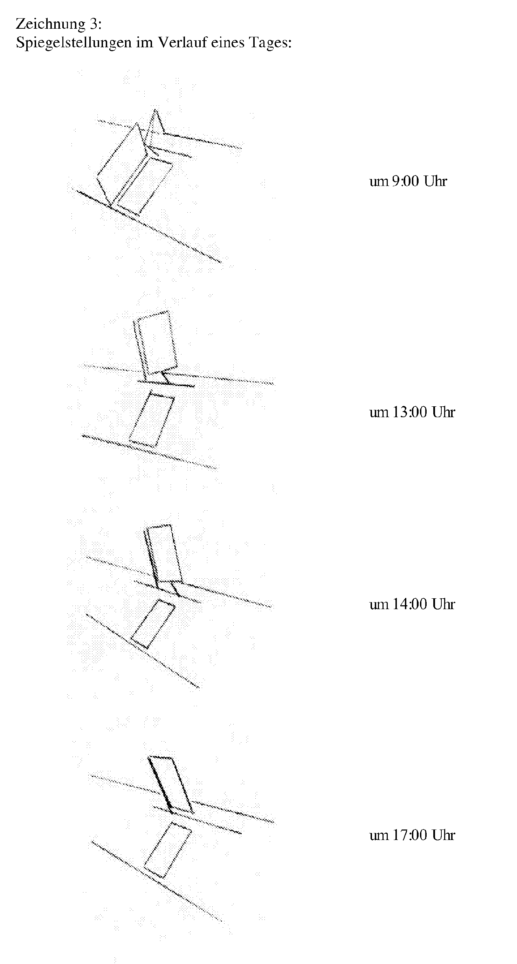

- Zeichnung 3 - Ansichten zu verschiedenen Uhrzeiten

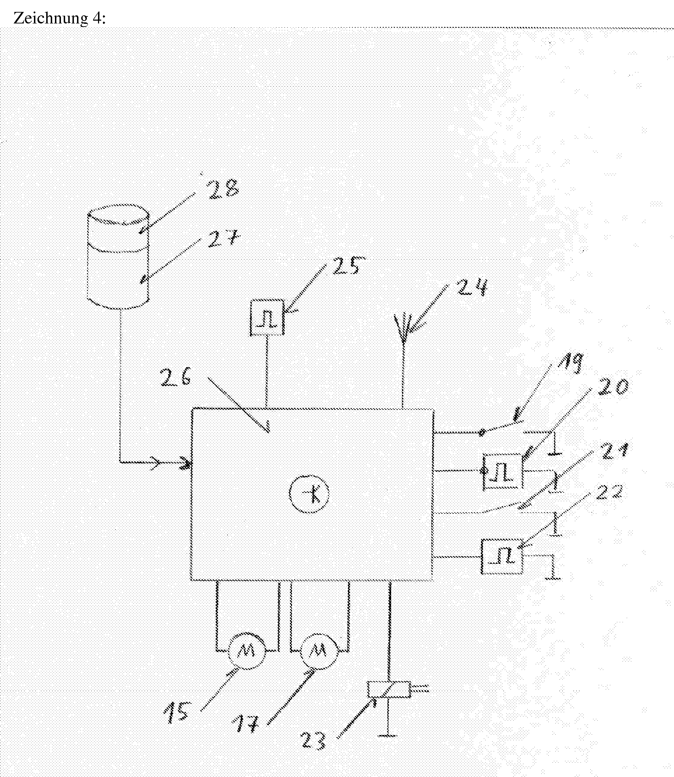

- Zeichnung 4 - Schaltbild

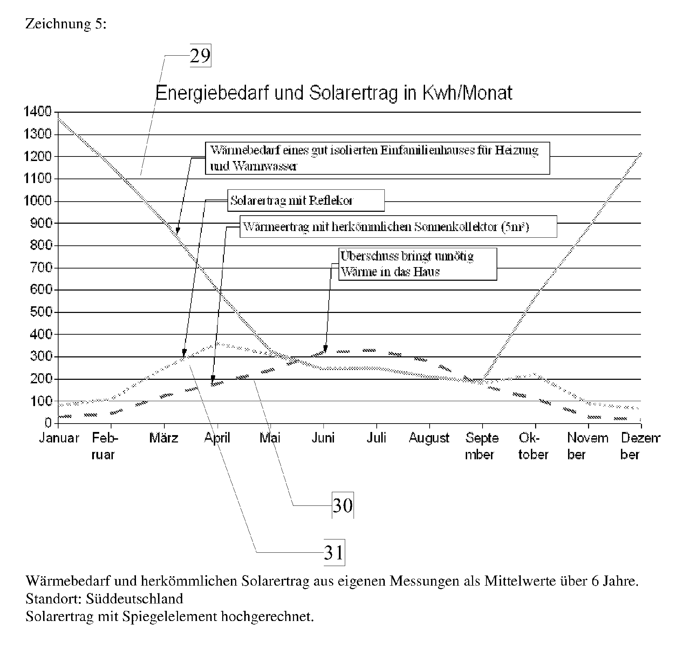

- Zeichnung 5 - Ertragsdiagramm

## Patentansprüche

1. Verwendung eines im wesentlichen L-förmigen um eine feste Achse **(5)** schwenkbaren Trägers **(3)** zur Führung eines Reflektors/Spiegels **(4)** zur Leistungssteigerung und/oder Leistungssteuerung von Sonnenkollektoren und/oder Photovoltaikanlagen **dadurch gekennzeichnet, daß** der erste Schenkel im wesentlichen parallel zur festen Achse **(5)** liegt und daß der zweite Schenkel etwa im rechen Winkel zum ersten Schenkel steht.

2. Anordnung einer zweiten Achse **(6)** am zweiten Schenkel des Trägers **(3)** gemäß Anspruch 1. zur drehbaren Lagerung des Reflektors/spiegels **(4)** zur Leistungssteigerung und/oder Leistungssteuerung von Sonnenkollektoren und/oder Photovoltaikanlagen **(2).**

3. Ausführung der Bewegung der Bauteile gemäß der Ansprüche 1. und 2. durch verschiebbare Schlitten **(7) (8)** sowie Schubstangen **(9) (10).** Lagerung der Schlitten **(7) (8)** auf den beiden Schenkeln des L-förmigen Trägers **(3) .**

4. Antrieb der Schlitten **(7) (8)** gemäß Anspruch 3. mittels Spindelgetrieben **(16) (18),** Zahnrad/Zahnstangengetrieben oder Zahnriemengetrieben und Elektromotoren **(15) (17).**

5. Sicherung eines Reflektors/Spiegels **(4)** zur Leistungssteigerung und/oder Leistungssteuerung von Sonnenkollektoren und/oder Photovoltaikanlagen gegen Sturmschäden durch ein elektrisch ver- und/oder entriegelbares Schloß **(23).**

6. Steuerung **(26)** eines Antriebs zur Führung mindestens eines Reflektors / Spiegels (4) zur Leistungssteigerung und/oder Leistungssteuerung von Sonnenkollektoren und/oder Photovoltaikanlagen abhängig von einem aus astronomischen Daten/Formeln **(27),** Uhrzeit **(24)** und Datum **(24)** errechneten Sonnenstand.

7. Verwendung der Eingangsgrößen Längengrad und Breitengrad **(28)** des Standorts sowie die Ausrichtung und Größe des Kollektors als einzustellende Parameter **(28)** der Steuerung **(26)** gemäß des Anspruchs 6.

8. Empfang von Funksignalen und/oder Telekommunikationssignalen zur Nutzung der Größen Datum und Uhrzeit **(24)** um die Steuerung **(26)** gemäß der Ansprüche 6. bis 7. auszuführen

9. Eingabemöglichkeit einer maximalen Speichertemperatur für Pufferspeicher von Sonnenkollektoren in die Steuerung gemäß des Ansprüchs 5. oberhalb der die Leistungsbegrenzung einsetzt.

10. Eingabemöglichkeit von Zeiten, in denen kein Energiebedarf vorliegt, in die Steuerung gemäß des Anspruchs 5., um die Leistungsbegrenzung gemäß Anspruch 9. zeitabhängig zu verändern. (Urlaubsschaltung)

11. Erfassung der Ist-Position eines Reflektors/Spiegels **(4)** zur Leistungssteigerung und/oder Leistungssteuerung von Sonnenkollektoren und/Photovoltaikanlagen mit Drehwinkelsensoren oder alternativ mit einer Kombination aus Endschaltern **(19) (21)** und Motor-/Spindelumdrehungen zählenden Sensoren **(20) (22)** als Eingangsgrößen in die Steuerung gemäß des Anspruchs 6.
